# EUROPÄISCHE PATENTSCHRIFT

(11) **EP 0 557 756 B1**
(45) Veröffentlichungstag und Bekanntmachung des Hinweises auf die Patenterteilung: **27.12.1995**
(21) Anmeldenummer: 93101734.7
(22) Anmeldetag: 04.02.1993
(51) Int. Cl.: B23K 1/20, B23K 35/38

(54) **Verfahren zum Verlöten von Leiterplatten**
Method for soldering printed circuit boards
Procédé pour le soudage de circuits imprimés

(30) Priorität: 27.02.1992 DE 4206103
(43) Veröffentlichungstag der Anmeldung: 01.09.1993
(73) Patentinhaber: Linde Aktiengesellschaft, 65189 Wiesbaden (DE)
(72) Erfinder: Wandke, Ernst, Dr.-Ing., W-8192 Geretsried (DE); Rief, Stefan, Dipl.-Ing., W-8000 München 80 (DE)
(74) Vertreter: Schaefer, Gerhard, Dr.

(56) Entgegenhaltungen:
- EP-A- 0 047 663
- EP-A- 0 371 693
- EP-A- 0 427 020
- US-A- 4 699 689
- PATENT ABSTRACTS OF JAPAN vol. 013, no. 235 (E-766)30. Mai 1989 & JP-1041218 (NEC Corp.) 13.Februar 1989 Zusammenfassung

## Beschreibung

Die Erfindung betrifft ein Verfahren zum Verlöten von bestückten Leiterplatten mit einem Vorreinigungsschritt, bei dem die Leiterplatten mit einem aus einem Prozeßgas erzeugten Plasma behandelt werden, wobei das Prozeßgas aus O₂, H₂, N₂O, Cl₂, N₂, Ar, FKW (Fluorkohlenwasserstoffen) oder FCKW (chlorierte Flurkohlenwasserstoffe) oder Mischgasen davon bestehen kann.

Der Einsatz von elektronischen Baueinheiten, die in Form von Leiterplatten mit einsteckbaren oder oberflächenmontierbaren elektronischen Bauelementen (=Surface Mounted Devices = SMDs), die abschließend zu verlöten sind, gestaltet werden, erfährt einen ständigen Zuwachs. Zur Herstellung dieser Baueinheiten ist die Leiterplatte mit entsprechenden Bauelementen zu bestücken, wobei diese auf irgend eine Weise, z.B. mit einem Klebstoff, vorläufig zu fixieren und - je nach Lötprinzip - gegebenenfalls auch bereits mit einer Lotpaste oder Lot-preforms auf den Lötvorgang vorzubereiten sind. Der im Anschluß daran auszuführende Lötvorgang, bei dem die Verlötung der Bauteilanschlüsse mit den Leiterbahnen der Leiterplatte zu bewirken ist, erfolgt einerseits in bekannter und gängiger Weise mit Wellenlötanlagen, bei denen Lot durch eine oder mehrere, die Leiterplatten von unten berührenden Lotwellen auf entsprechende Bereiche aufgebracht wird. Zum anderen ist bei mit Lotpaste oder Lot-preforms aufgebrachten Bauteilen lediglich ein Aufschmelzen des Lotanteils der Paste oder der Lot-preforms zu bewirken (Reflowlöten).

In beiden Fällen sind allerdings für eine gute Qualität der Lötverbindung Flußmittel anzuwenden. Entweder werden diese im Falle der Wellenlötung vor dem eigentlichen Lötvorgang aufgebracht, oder es enthält die angewendete Lotpaste oder Lot-preform sowohl Lot als auch Flußmittel. Die Flußmittel dienen dem Lötprozeß vor allem insofern, als sie die die Lötung beeinträchtigende Metalloxidschicht auf dem Werkstück zerstören sowie eine Oxidation der beteiligten Metalle beim Lötvorgang verhindern. Zudem wird die Oberflächenspannung des verflüssigten Lots vermindert. Flußmittel sind also multifunktional und dementsprechend aus einer Vielzahl von Substanzen zusammengesetzt. Nach dem Lötvorgang verbleiben jedoch Rückstände der Flußmittel auf den Leiterplatten, die zu nachteiligen Konsequenzen führen. Dazu gehören die Verringerung des Isolationswiderstandes zwischen auf der Leiterplatte befindlichen Leiterbahnen oder die vorschnelle Korrosion der Leiterbahnen. Deshalb sind die Flußmittelrückstände zu entfernen. Dies wird bekanntermaßen durch eine Reinigungsbehandlung der Platten mit FCKWs oder CKWs nach dem Lötvorgang erreicht. Die Anwendung der eben genannten und in bekannter Weise umweltschädigenden Stoffe - FCKW-Ozon-Problematik - soll jedoch heute minimiert oder gänzlich vermieden werden.

In einer neueren Vorgehensweise gemäß der DE-PS 39 36 955 wird die Notwendigkeit der die Nachreinigung verursachenden Flußmitteln dadurch herabgesetzt, daß der Verlötung der Platinen eine Niederdruck-Plasma-Behandlung derselben vorgeschaltet wird,wobei das Plasma aus einem Prozeßgas z.B.unter Mikrowellenanwendung erzeugt wird . Als Prozeßgase sind gemäß der besagten DE-PS O₂, H₂, Cl₂, N₂O, N₂, Ar, FKW oder FCKW oder Kombinationen dieser Stoffe vorgeschlagen. Durch die Behandlung mit einem derartigen Plasma werden der DE-PS zufolge die Oxide an der Leiterplattenoberfläche und insbesondere an den Lötstellen abgetragen und somit die Verlöteigenschaft der Fügeparteien verbessert. Dieser Plasmabehandlung nachfolgend ist dann der Lötvorgang auszuführen, wobei abschließend die naßchemische Nachreinigung der Leiterplatten unterbleiben kann.

Es hat sich jedoch gezeigt, daß bei dem Verfahren gemäß der DE-PS und insbesondere mit der dort angegebenen Prozeßgasmischung mit etwa 83 Vol% CF₄ und 17 Vol% O₂ kein vollständiger Verzicht auf Flußmittel bzw. ähnlich wirkende Hilfsstoffe und demzufolge auf eine entsprechende Nachreinigung möglich ist.

Der Erfindung liegt daher die Aufgabe zugrunde, ein Prozeßgas zur Anwendung bei einer Plasmavorbehandlung in einem Lötverfahren anzugeben, welches eine anschließende Lötung ohne den Einsatz von Flußmitteln oder ähnlich wirkenden Hilfsstoffen ermöglicht und welches somit eine Nachreinigung der Leiterplatten von Flußmittelrückständen gänzlich überflüssig macht.

Diese Aufgabe wird mit einem Prozeßgas gelöst, das aus
0.5 bis 10 Vol% Sauerstoff,
20 bis 80 Vol% Wasserstoff und aus
80 bis 20 Vol% CF₄ besteht.
Als besonders effizient hat sich ein Vorreinigungsschritt ergeben, bei dem als Prozeßgas ein Gasgemisch aus
2 bis 6 Vol% Sauerstoff,
45 bis 55 Vol% Wasserstoff und
40 bis 50 Vol% CF₄ verwendet wird.

Mit den erfindungsgemäßen Gasgemischen als Prozeßgas wird nun tatsächlich der vollständige Verzicht auf Flußmittel beim Lötvorgang unter Erhaltung eines hochwertiges Lötergebnis ermöglicht. Die vorgeschlagenen Gasmischungen beruhen auf einer sehr gezielten Auswahl von Gaskomponenten, wobei die Wirkung dahingehend sein mußte, daß diese Gasmischung insbesondere im Plasmazustand sowohl eine Oxidationswirkung als auch eine Reduktionswirkung besitzt. Eben geschilderte Zielsetzung beruht auf der Erkenntnis, daß bei betreffenden Lötvorgängen einerseits auf der Oberfläche der Leiterplatte sitzende, adsorptiv gebundene oxidierbare Substanzen, z.B. Fette und Öle, entfernt werden müssen und andererseits auch die immer vorhandene, beim Lötvorgang störende Metalloxid-Oberflächenschicht zu beseitigen ist. Diese Aufgaben werden ansonsten durch die zugegebenen Flußmittel gelöst. Erfindungsgemäß gelingt es aber, dies, durch die gezielt zu einen Plasmagas kombinierten Stoffe Sauerstoff, Wasserstoff und Tetrafluorkohlenstoff, in Form einer Plasmavorbehandlung zu bewerkstelligen.

Ein wirksamer und vorteilhafter Plasma-Vorbehandlungsschritt mit dem erfindungsgemäßen Prozeßgas ist ferner dadurch gekennzeichnet, daß er bei einem Druck von weniger als 200 mbar, vorzugsweise 0.5 bis 50 mbar, einer Anregungsleistung einer Mikrowellenquelle von 200 bis 600 Watt und/oder einer Erregerspannung einer Glimmentladung von 200 bis 1000 V, einer Temperatur von 50 bis 200 °C und mit einer Dauer von 30 s bis 5 min durchgeführt wird.

Ein Lötablauf insgesamt kann im übrigen z.B. in der Weise erfolgen, wie dies in der bereits genannten DE-PS 3936 955 geschildert ist. Prinzipiell ist der erfindungsgemäße Vorbehandlungsschritt selbstverständlich in vielen gängigen Lötverfahren anwendbar.

## Patentansprüche

1. Verfahren zum Verlöten von bestückten Leiterplatten bei dem ein Vorreinigungsschritt ausgeführt wird , bei dem die Leiterplatten mit einem aus einem Prozeßgas erzeugten Plasma behandelt werden, wobei das Prozeßgas aus O₂, H₂, N₂O, Cl₂, N₂, Ar, FKW oder FCKW oder Mischungen davon bestehen kann,**dadurch gekennzeichnet**,
daß als Prozeßgas ein aus
0.5 bis 10 Vol% Sauerstoff,
20 bis 80 Vol% Wasserstoff und
80 bis 20 Vol% CF₄ bestehendes Gasgemisch verwendet wird.

2. Verfahren nach Anspruch 1, dadurch gekennzeichnet, daß als Prozeßgas ein Gasgemisch aus
2 bis 6 Vol% Sauerstoff,
45 bis 55 Vol% Wasserstoff und
40 bis 50 Vol% CF₄ verwendet wird.

3. Verfahren nach einem der Ansprüche 1 bis 2, dadurch gekennzeichnet, daß die Plasmavorbehandlung bei einem Druck von weniger als 200 mbar, vorzugsweise 0.5 bis 50 mbar, einer Anregungsleistung einer Mikrowellenquelle von 200 bis 600 Watt und/oder einer Erregerspannung einer Glimmentladung von 200 bis 1000 V, einer Temperatur von 50 bis 200 °C und mit einer Dauer von 30 s bis 5 min durchgeführt wird.

4. Verfahren nach einem der Ansprüche 1 bis 3, dadurch gekennzeichnet, daß das Prozeßgas als fertiges Gasgemisch in Speicherbehältern bereitgestellt wird.

## Claims

1. Process for soldering circuit boards fitted with devices in which a preliminary cleaning step is performed in which the circuit boards are treated with a plasma produced from a process gas, for which the process gas can consist of 0₂, H₂, N₂O, Cl₂, N₂, Ar, FCs or CFCs or mixtures thereof, characterized in that a gas mixture consisting of
0.5 to 10% by volume oxygen,
20 to 80% by volume hydrogen and
80 to 20% by volume CF₄
is used as process gas.

2. Process according to claim 1, characterized in that a gas mixture consisting of
2 to 6 % by volume oxygen,
45 to 55% by volume hydrogen and
40 to 50% by volume CF₄
is used as process gas.

3. Process according to one of claims 1 to 2, characterized in that the plasma preliminary treatment is carried out with a pressure of less than 200 mbar, preferably 0.5 to 50 mbar, a microwave source excitation power of 200 to 600 watts and/or a glow discharge excitation voltage of 200 to 1000 V, a temperature of 50 to 200°C and a duration of 30 s to 5 mins.

4. Process according to one of claims 1 to 3, characterised in that the process gas is provided in the form of a finished gas mixture in storage containers.

## Revendications

1. Procédé pour la soudure de cartes à circuit imprimé équipées dans lequel on réalise une étape de pré-nettoyage, les cartes à circuit imprimé étant traitées au moyen d'un plasma obtenu à partir d'un gaz de traitement, ce gaz de traitement pouvant être composé de O₂, H₂, N₂O, Cl₂, N₂, Ar, FC ou CFC ou de leurs mélanges, ce procédé étant caractérisé en ce qu'on utilise en tant que gaz de traitement, un mélange gazeux composé de:
0,5 à 10 vol. % d'oxygène,
20 à 80 vol.% d'hydrogène et
80 à 20 vol. % CF₄.

2. Procédé selon la revendication 1, caractérisé en ce qu'on utilise en tant que gaz de traitement, un mélange gazeux composé de:
2 à 6 vol. % d'oxygène,
45 à 55 vol.% d'hydrogène et
40 à 50 vol. % CF₄.

3. Procédé selon l'une des revendications 1 et 2, caractérisé en ce que le pré-traitement du plasma est réalisé sous une pression inférieure à 200 mbar, de préférence de 0,5 à 50 mbar, une puissance d'excitation d'une source de micro-ondes de 200 à 600 Watt et/ou une tension d'excitation d'une décharge luminescente de 200 à 1000 V, une température de 50 à 200°C et pendant une durée de 30 s. jusqu'à 5 min.

4. Procédé selon l'une des revendications 1 à 3, caractérisé en ce que le gaz de traitement est disponible sous forme d'un mélange de gaz contenu dans des récipients de stockage.
